# EUROPÄISCHE PATENTSCHRIFT

(11) **EP 2 623 937 B1**
(45) Veröffentlichungstag und Bekanntmachung des Hinweises auf die Patenterteilung: **23.05.2018**
(21) Anmeldenummer: 13151101.6
(22) Anmeldetag: 14.01.2013
(51) Int. Cl.: G01D 5/26, G01D 5/38

(54) **Positionsmesseinrichtung und Anordnung mit mehreren Positionsmesseinrichtungen**
Position measuring device and assembly with multiple position measuring devices
Dispositif de mesure de position et agencement à plusieurs dispositifs de mesure de position

(30) Priorität: 01.02.2012 DE 102012201393
(43) Veröffentlichungstag der Anmeldung: 07.08.2013
(73) Patentinhaber: Dr. Johannes Heidenhain GmbH, 83301 Traunreut (DE)
(72) Erfinder: Holzapfel, Wolfgang, 83119 Obing (DE); Drescher, Jörg, 83122 Samerberg (DE); Meissner, Markus, 83236 Übersee (DE); Joerger, Ralph, 83278 Traunstein (DE); Musch, Bernhard, 83624 Otterfing (DE); Kälberer, Thomas, 86529 Schrobenhausen (DE)

(56) Entgegenhaltungen:
- DE-A1-102006 042 007
- JP-A- 2011 117 737
- US-A1- 2005 259 268
- US-A1- 2009 135 388

## Beschreibung

Die vorliegende Erfindung betrifft eine Positionsmesseinrichtung.

In Maschinen, die bei der Fertigung und Prüfung von Halbleiterbauelementen zum Einsatz kommen, besteht oftmals die Anforderung, Objekte präzise zu positionieren. So kann es etwa erforderlich sein, Wafer hochgenau unterhalb eines Werkzeugs einer Belichtungs- oder Inspektionseinheit zu positionieren. Der Wafer liegt dabei auf einem in sechs Freiheitsgraden beweglichen Tisch, der über einen entsprechenden Antrieb bewegt wird. Als Objekt, dessen Position hochgenau zu erfassen ist, fungiert hier also der Tisch; um diesen Tisch über den Antrieb und eine zugehörige Steuereinheit zu positionieren, ist die Erzeugung von Positionssignalen zur räumlichen Lage des Tisches mittels hochgenauer Positionsmesseinrichtungen erforderlich.

Als hochgenaue Positionsmesseinrichtungen dienen in derartigen Maschinen üblicherweise Interferometer oder aber gitterbasierte optische Positionsmesseinrichtungen. Bei beiden Arten von Positionsmesseinrichtungen resultieren jedoch Probleme, wenn der Verfahrweg des Tisches entlang einer vorgesehenen Bewegungsachse größer als die Ausdehnung bzw. Länge des Tisches in dieser Bewegungsachse ist.

Mit Hilfe von Interferometern wird die Position des Tisches in einer Verfahrrichtung bzw. Bewegungsachse üblicherweise durch Antasten eines Messreflektors in Form eines Spiegels mit einem Messstrahl erfasst. Der Messstrahl verläuft dabei parallel zu der erfassten Bewegungsachse und ist positionsfest mit der Maschine verankert. Bewegt sich der Tisch nun zusätzlich in einer zweiten Verfahrrichtung, so muss sichergestellt werden dass bei jeder Position des Tisches der Messstrahl auf den Spiegel trifft. Ist die zweite Verfahrrichtung größer als die Seitenlänge des Tisches und damit auch größer als die Seitenlänge des am Tisch angebrachten Spiegels, so trifft in bestimmten Positionen der Messstrahl nicht mehr auf den Spiegel und das Interferometer kann keine korrekten Positionssignale mehr erzeugen, d.h. das Interferometer verliert die erfasste Position. Um einen derartigen Verlust der Position zu vermeiden, muss daher der Spiegel mit dem Messstrahl einer zusätzlichen zweiten Interferometerachse abgetastet werden, der zum ersten Messstrahl in der zweiten Verfahrrichtung so versetzt ist, dass bei jeder Tischposition mindestens einer der beiden Messstrahlen auf den Spiegel trifft. Da Interferometer eine Position üblicherweise nur inkrementell und nicht absolut erfassen, ist es desweiteren erforderlich, dass die Absolutposition zwischen beiden Interferometerachsen übergeben wird, bevor einer der Messstrahlen nicht mehr auf den Spiegel trifft; man spricht hier von einer sogenannten Positionsübergabe. Mit Hilfe von Interferometern, die die Tischposition von außen, d.h. von einem festen Bezugssystem her, erfassen, ist daher ohne weitere Hilfsachsen und Positionsübergabe nur ein maximaler Verfahrweg messbar, der der Länge des Tisches entlang der jeweiligen Bewegungsachse entspricht.

Führt man alternativ hierzu die entsprechenden Interferometer-Komponenten auf dem bewegten Tisch mit und misst mit dem Interferometer nach außen in Richtung des festen Bezugssystems, so ergeben sich Probleme im Zusammenhang mit der Lichtzuführung und der Detektion der Interferometersignale. Ferner erhöht sich durch die zusätzlichen Interferometer-Komponenten auf dem Tisch die Masse des bewegten Tisches, was dessen dynamisches Verhalten verschlechtert.

Zudem resultiert als weiterer Nachteil ein insgesamt recht großer Messzirkel. Dies bedeutet, dass das Interferometer die Position des Tisches nicht direkt relativ zum jeweiligen Werkzeug, sondern relativ zu einer entfernten Referenz erfasst, üblicherweise dem Montageort einer Optikeinheit des Interferometers, d.h. dem Interferometerkopf. Damit geht eine eventuelle Drift der Position zwischen der Optikeinheit und dem Werkzeug direkt in eine Drift der gemessenen Position ein. Der räumliche Abstand zwischen der Optikeinheit und dem Werkzeug kann typischerweise im Bereich von 1 - 2m liegen; die geforderten Messgenauigkeiten liegen für derartige Applikationen hingegen im nm-Bereich.

Um die Bewegung des Tisches entlang zwei zueinander senkrechter Bewegungsachsen mittels Interferometern zu erfassen, ist weiterhin erforderlich, dass der bewegte Tisch von zwei Seiten her optisch zugänglich ist, was wiederum bestimmte Restriktionen beim Design der jeweiligen Maschine zur Folge hat.

Im Zusammenhang mit derartigen Interferometer-Lösungen sei beispielsweise auf die DE 10 2006 042 007 A1 verwiesen. Darin wird ein Interferometer vorgeschlagen, das einen grossen Dynamikbereich fuer Messungen entlang einer vertikalen und einer horizontalen Richtung aufweist.

Im Fall des Einsatzes von gitterbasierten Positionsmesseinrichtungen, bestehend aus einer Maßverkörperung und ein oder mehreren Abtasteinheiten, ist die verfügbare Messlänge durch die Länge der jeweiligen Maßverkörperung begrenzt. Für eine hochdynamische Anwendung, wie im vorliegenden Fall, ist es grundsätzlich vorteilhaft, die Abtasteinheit einer solchen Positionsmesseinrichtung im festen Bezugssystem anzuordnen und die Maßverkörperung auf dem bewegten Tisch. Andererseits sollte der Tisch jedoch möglichst kompakt bauend ausgeführt sein, was die mögliche Länge der Maßverkörperung wiederum stark einschränkt. Insbesondere erweist es sich als ungünstig, für die Maßverkörperung eine Länge zu wählen, die größer als die des bewegten Tisches entlang der Bewegungsachse ist. Auch mit einem solchen Aufbau herkömmlicher gitterbasierter Positionsmesseinrichtungen erweist sich somit die Realisierung von Verfahrwegen insbesondere in den eingangs erwähnten Anwendungen als problematisch, wenn der erforderliche Verfahrweg größer als die Länge des bewegten Tisches entlang dieser Bewegungsachse ist.

Montiert man hingegen umgekehrt die Abtasteinheiten der gitterbasierten Positionsmesseinrichtung auf dem bewegten Tisch, so erhöht sich wiederum dessen Masse und beeinflusst dessen dynamisches Verhalten nachteilig. Ebenfalls als nachteilig erweisen sich hierbei die erforderlichen Kabelverbindungen die die Abtasteinheiten mit dem festen Bezugsystem verbinden.

In Bezug auf derartige Lösungen sei beispielsweise auf die JP 2011-117737 A erwähnt. Daraus ist die Erfassung der Position eines beweglichen Tisches entlang mehrerer Bewegungsrichtungen mit Hilfe mehrerer am Tisch angeordneten Maßverkörperungen bekannt.

Im Zusammenhang mit dem vorhergehend diskutierten Stand der Technik sei ferner auf die Druckschriften EP 1 469 351 A1, US 7,907,287 B2, US 7,751,060 B2 sowie auf den Vortrag von Prof. Dr.-Ing. habil. Gerd Jäger zur 3. ITG/GMA-Fachtagung "Sensoren und Messsysteme" (9.-11.3.1998, Bad Nauheim) mit dem Titel "Laserinterferometrische Meßverfahren - Möglichkeiten, Grenzen und Anwendungen" verwiesen.

Aufgabe der vorliegenden Erfindung ist es, Lösungen zur hochgenauen Positionserfassung eines beweglichen Objektes anzugeben, über die zumindest entlang einer Bewegungsachse des Objektes ein von der Ausdehnung des Objektes unabhängiger Verfahrweg realisierbar ist.

Diese Aufgabe wird gelöst durch eine Positionsmesseinrichtung mit den Merkmalen des Anspruches 1.

Ferner wird dieses Aufgabe gelöst durch eine Positionsmesseinrichtung mit den Merkmalen des Anspruches 5.

Vorteilhafte Ausführungsformen der erfindungsgemäßen Lösungen finden sich in den jeweils abhängigen Ansprüchen.

Erfindungsgemäß ist als erste Lösung eine Positionsmesseinrichtung vorgesehen, welche zur Erfassung der Position eines Objekts entlang einer dritten Achse dient, die senkrecht zu zwei orthogonalen, ersten und zweiten Hauptbewegungsachsen des Objekts orientiert ist. Diese umfasst
- eine Lichtquelle, die ein Strahlenbündel entlang der ersten Hauptbewegungsachse in Richtung des Objekts emittiert,
- eine am Objekt angeordnete Maßverkörperung, die aus periodisch entlang der dritten Achse angeordneten Teilungsmarkierungen besteht,
- mindestens einen entlang der dritten Achse beabstandet vom Objekt angeordneten Reflektor,
- eine Retroreflektoranordnung und
- eine Detektoranordnung, wobei
   diese derart angeordnet und ausgebildet sind, dass aus der Überlagerung eines aus dem Strahlenbündel erzeugten Messstrahls und eines Referenzstrahls Positionssignale bezüglich der Bewegung des Objekts entlang der dritten Achse erzeugbar sind, wobei
- das von der Lichtquelle emittierte Strahlenbündel in der Retroreflektoranordnung eine Aufspaltung in einen Messstrahl und in einen Referenzstrahl erfährt,
- der Messstrahl in Richtung der Maßverkörperung propagiert und darüber eine erste Reflexion und Beugung in Richtung des Reflektors erfährt,
- der Messstrahl am Reflektor eine erste Rückreflexion in Richtung der Maßverkörperung erfährt,
- der Messstrahl an der Maßverkörperung eine erste Rückreflexion in Richtung der Retroreflektoranordnung erfährt, wo der Messstrahl eine Retroreflexion und Rückreflexion in Richtung der Maßverkörperung erfährt,
- der Messstrahl an der Maßverkörperung eine zweite Reflexion und Beugung in Richtung des Reflektors erfährt,
- der Messstrahl am Reflektor eine zweite Rückreflexion in Richtung der Maßverkörperung erfährt,
- der Messstrahl von der Maßverkörperung eine zweite Rückreflexion in Richtung der Retroreflektoranordnung erfährt und
- der Referenzstrahl die Retroreflektoranordnung durchläuft und dann
- eine Überlagerung mit dem nach der zweiten Rückreflexion an der Maßverkörperung her eintreffenden Messstrahl erfährt und das überlagerte Paar aus Mess- und Referenzstrahl in Richtung der Detektoranordnung propagiert.

In einer möglichen Ausführungsform kann die Retroreflektoranordnung ein Strahlteilerelement, einen Referenzreflektor sowie einen Retroreflektor umfassen.

Der Reflektor kann entweder
- als Auflicht-Beugungsgitter ausgebildet sein, das periodisch entlang der ersten Hauptbewegungsachse angeordnete Teilungsmarkierungen umfasst oder
- als Planspiegel ausgebildet sein, der senkrecht zum darauf einfallenden Messstrahl angeordnet ist.

Mit Vorteil ist die am Objekt angeordnete Maßverkörperung als Auflicht-Beugungsgitter derart ausgebildet, dass ein darauf einfallendes Strahlenbündel nur Beugung in +/- 1. Ordnung erfährt und die gebeugten Teilstrahlenbündel +/- 1. Ordnung eine Reflexion in Richtung des mindestens einen Reflektors erfahren.

Erfindungsgemäß ist als zweite Lösung eine Positionsmesseinrichtung vorgesehen, welche zur Erfassung der Position eines Objekts entlang einer zweiten Hauptbewegungsachse dient, wobei das Objekt beweglich entlang zweier orthogonaler, erster und zweiter Hauptbewegungsachsen angeordnet ist, mit
- einer Lichtquelle, die ein Strahlenbündel entlang der ersten Hauptbewegungsachse in Richtung des Objekts emittiert,
- einer am Objekt angeordneten Maßverkörperung, die periodisch entlang der zweiten Hauptbewegungsachse angeordnete Teilungsmarkierungen umfasst,
- mindestens einem in Richtung einer dritten Achse beabstandet vom Objekt angeordneten Reflektor, wobei die dritte Achse senkrecht zu den beiden ersten und zweiten Hauptbewegungsachsen orientiert ist,
- einer Retroreflektoranordnung und
- einer Detektoranordnung,
   welche derart angeordnet und ausgebildet sind, dass aus der Überlagerung eines aus dem Strahlenbündel erzeugten Messstrahls und eines Referenzstrahls Positionssignale bezüglich der Bewegung des Objekts entlang der zweiten Hauptbewegungsachse (x) erzeugbar sind, wobei
- das von der Lichtquelle emittierte Strahlenbündel in Richtung der Maßverkörperung propagiert und dort eine Aufspaltung in zwei Teilstrahlenbündel erfährt, welche als Mess- und Referenzstrahl zur interferentiellen Erzeugung von Positionssignalen nutzbar sind, und wobei die zwei Teilstrahlenbündel nach der Reflexion an der Maßverkörperung in unterschiedlichen Richtungen zum Reflektor propagieren,
- die beiden Teilstrahlenbündel am Reflektor jeweils eine erste Rückreflexion in Richtung der Maßverkörperung erfahren,
- die beiden Teilstrahlenbündel an der Maßverkörperung eine erste Rückreflexion in Richtung der Retroreflektoranordnung erfahren, wo die beiden Teilstrahlenbündel eine Retroreflexion und Rückreflexion in Richtung der Maßverkörperung erfahren,
- die beiden Teilstrahlenbündel an der Maßverkörperung eine zweite Reflexion und Beugung in Richtung des Reflektors erfahren,
- die beiden Teilstrahlenbündel am Reflektor eine zweite Rückreflexion in Richtung der Maßverkörperung erfahren,
- eine Wiedervereinigung der Teilstrahlenbündel an der Maßverkörperung erfolgt und von der Maßverkörperung ein überlagertes Strahlenbündel in Richtung der Detektoranordnung propagiert.

Der Reflektor kann entweder
- zwei, in Richtung der zweiten Hauptbewegungsachse beabstandete Auflicht-Beugungsgitter umfassen, die periodisch angeordneten Teilungsmarkierungen aufweisen oder
- zwei, in Richtung der zweiten Hauptbewegungsachse beabstandete Planspiegel umfassen, die jeweils senkrecht zum darauf einfallenden Messstrahl angeordnet sind.

Mit Vorteil ist die am Objekt angeordnete Maßverkörperung als Auflicht-Beugungsgitter derart ausgebildet, dass ein darauf einfallendes Strahlenbündel nur Beugung in +/- 1. Ordnung erfährt und die gebeugten Teilstrahlenbündel +/- 1. Ordnung als Messstrahl und Referenzstrahl eine Reflexion in Richtung des mindestens einen Reflektors erfahren.

Es ist möglich, dass die am Objekt angeordnete Maßverkörperung entweder
- als eindimensionale Maßverkörperung ausgebildet ist, die unter einem Winkel ungleich 0° zur dritten Achse (z) am Objekt angeordnet ist oder
- als zweidimensionale Maßverkörperung ausgebildet ist, die parallel zur dritten Achse am Objekt angeordnet ist und ferner periodisch entlang der dritten Achse angeordnete Teilungsmarkierungen umfasst.

Über die erfindungsgemäßen Maßnahmen lässt sich somit der geforderte lange Verfahrweg des Objektes entlang einer Bewegungsachse realisieren und gleichzeitig die hochgenaue Positionserfassung des Objekts gewährleisten.

Die erfindungsgemäßen Lösungen erfordern hierbei nicht, die Masse des bewegten Objektes aufgrund zusätzlicher Komponenten von Positionsmesseinrichtungen zu erhöhen. Ebenso kann auf Kabelverbindungen des bewegten Objektes mit dem festen Bezugssystem verzichtet werden, d.h. am bewegten Objekt sind ausschließlich passive Komponenten der Positionsmesseinrichtung(en) angeordnet.

In einer möglichen Ausführung einer erfindungsgemäßen Anordnung kann die Erfassung aller sechs Freiheitsgrade eines entsprechend beweglich gelagerten Objektes erfolgen.

Grundsätzlich ist es hierbei möglich, die erste und zweite erfindungsgemäße Positionsmesseinrichtung auch jeweils unabhängig von der Gesamtanordnung einzusetzen, wenn sich eine entsprechende Messaufgabe ergibt.

Als besonders vorteilhaft an einer beispielhaften Anordnung ist schließlich zu erwähnen, dass zur Messung aller sechs Freiheitsgrade des entsprechenden Objekts dieses lediglich aus einer einzigen Antastrichtung optisch angetastet bzw. abgetastet werden muss. Dies erfolgt vorzugsweise aus derjenigen Richtung, die der längeren Hauptbewegungsachse entspricht. Auf diese Art und Weise resultieren erweiterte konstruktive Möglichkeiten, wenn das entsprechende Objekt etwa als verfahrbarer Tisch in einer Maschine ausgebildet ist.

Weitere Einzelheiten und Vorteile der vorliegenden Erfindung seien anhand der nachfolgenden Beschreibung von Ausführungsbeispielen in Verbindung mit den Figuren erläutert.

Es zeigt
- Figur 1: eine Prinzipskizze zur Definition der verschiedenen Achsen, entlang derer sich das Objekt bewegt;
- Figur 2a: eine stark schematisierte Darstellung des Abtaststrahlengangs einer ersten erfindungsgemäßen Positionsmesseinrichtung in einer ersten Ansicht (zy-Ebene);
- Figur 2b: eine stark schematisierte Darstellung des Abtaststrahlengangs der ersten erfindungsgemäßen Positionsmesseinrichtung in einer zweiten Ansicht (xy-Ebene);
- Figur 2c: eine Draufsicht auf die Maßverkörperung der ersten erfindungsgemäßen Positionsmesseinrichtung;
- Figur 2d: eine Draufsicht auf den Reflektor der ersten erfindungsgemäßen Positionsmesseinrichtung;
- Figur 3a: eine stark schematisierte Darstellung des Abtaststrahlengangs einer zweiten erfindungsgemäßen Positionsmesseinrichtung in einer ersten Ansicht (zy-Ebene);
- Figur 3b: eine stark schematisierte Darstellung des Abtaststrahlengangs der zweiten erfindungsgemäßen Positionsmesseinrichtung in einer zweiten Ansicht (xy-Ebene);
- Figur 3c: eine Draufsicht auf den Reflektor der zweiten erfindungsgemäßen Positionsmesseinrichtung;
- Figur 3d: eine vergrößerte Darstellung eines Teils des Strahlenganges der zweiten erfindungsgemäßen Positionsmesseinrichtung (zy-Ebene);
- Figur 4a: eine stark schematisierte Darstellung einer beispielhaften Anordnung in einer ersten Ansicht (zy-Ebene);
- Figur 4b: eine stark schematisierte Darstellung der beispielhaften Anordnung in einer zweiten Ansicht (xy-Ebene);
- Figur 4c: eine Draufsicht auf den Messreflektor und die Maßverkörperungen der beispielhaften Anordnung;
- Figur 4d: eine Draufsicht auf den Reflektor der beispielhaften Anordnung.

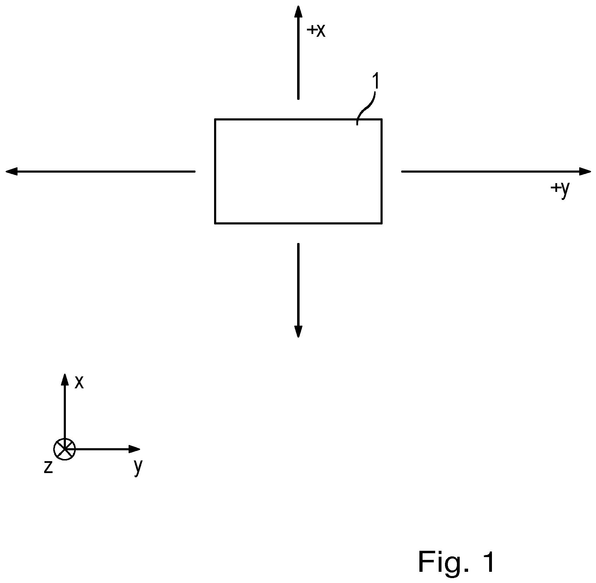

Figur 1 zeigt eine Prinzipskizze, anhand der für die nachfolgende Beschreibung die verschiedenen Achsen x, y, z definiert werden, entlang der sich das Objekt 1 bewegt und dessen Bewegung entlang der verschiedenen x, y, z erfasst werden soll. Beim nur schematisiert dargestellten Objekt 1 handelt es sich z.B. um den Tisch einer Maschine, die zur Halbleiter-Fertigung oder zur Halbleiter-Inspektion eingesetzt wird. Auf dem Tisch kann etwa ein Wafer angeordnet sein, der zur Bearbeitung oder Inspektion relativ zu einer anderen Maschinenkomponente hochpräzise positioniert werden soll. Der Tisch respektive das Objekt 1 bewegt sich hierbei entlang einer langen Verfahrachse bzw. entlang einer ersten Hauptbewegungsachse y und entlang einer hierzu senkrechten, kürzeren zweiten Hauptbewegungsachse x; desweiteren ist eine Bewegung des Objektes 1 entlang einer dritten Achse z möglich, die wiederum senkrecht auf die erste und zweite Hauptbewegungsachse y, x ausgerichtet ist. Entlang der ersten Hauptbewegungsachse y ist demzufolge ein längerer Verfahrweg für das Objekt 1 vorgesehen als entlang der hierzu senkrechten zweiten Hauptbewegungsachse x. Zudem ist im vorliegenden Ausführungsbeispiel der Verfahrweg entlang der ersten Hauptbewegungsachse y länger als die Ausdehnung des Objektes 1 entlang dieser Hauptbewegungsachse y.

Neben der Erfassung der linearen Objektbewegung entlang der zwei Hauptbewegungsachsen x, y und der dritten Achse z ist zur hochgenauen Positionierung des Objekts 1 ferner die messtechnische Erfassung von Rotationsbewegungen des Objekts 1 um die drei verschiedenen Achsen x, y, z erforderlich, um die Position des Objekts 1 im Raum in allen sechs Freiheitsgraden zu bestimmen. Die Rotationsbewegungen des Objekts 1 um die Achsen x, y, z werden nachfolgend als Rx-, Ry- und Rz-Bewegung bezeichnet.

Zur Erfassung aller sechs Freiheitsgrade des bewegbaren Objektes 1 dienen mehrere Positionsmesseinrichtungen, die geeignet zu einer Anordnung bzw. einem Gesamtsystem kombiniert werden können. Zwei dieser Positionsmesseinrichtungen, die auch unabhängig vom Gesamtsystem zur Erfassung von sechs Freiheitsgraden zum Einsatz kommen können, werden nachfolgend als erste und zweite Lösung jeweils separat beschrieben. Abschließend wird das Gesamtsystem zur Erfassung aller sechs Freiheitsgrade als beispielhafte Anordnung aus mehreren Positionsmesseinrichtungen erläutert.

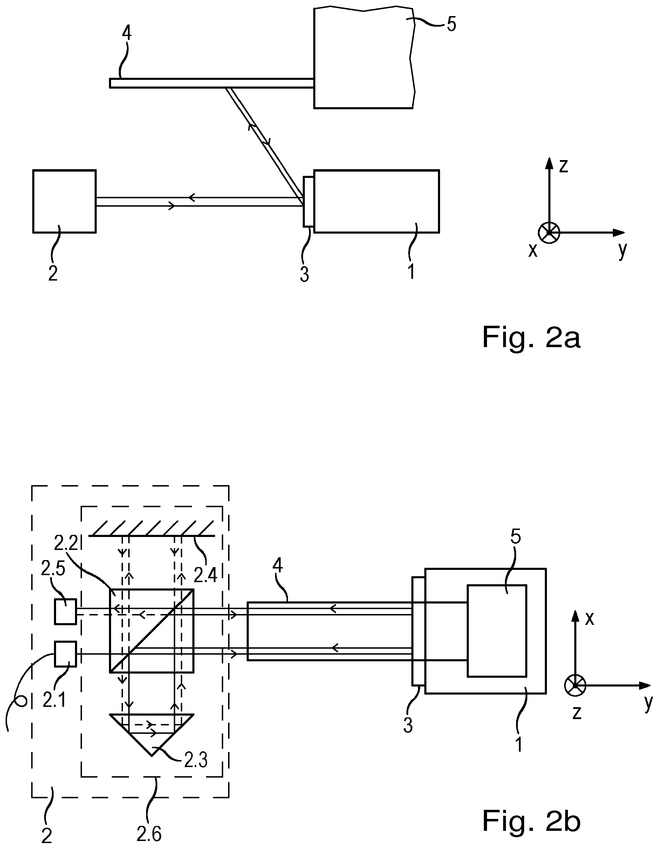

Nachfolgend sei zunächst anhand der stark schematisierten Darstellungen in den Figuren 2a - 2d eine erste erfindungsgemäße Positionsmesseinrichtung beschrieben, die i.w. zur Erfassung der Objektbewegung entlang der dritten Achse z dient, welche senkrecht zu den beiden Hauptbewegungsachsen x, y orientiert ist. Diese Lösung kann wie bereits erwähnt grundsätzlich auch unabhängig von der nachfolgend noch zu erläuternden Gesamt- (Anordnung) in einer entsprechenden Anwendung zum Einsatz kommen.

Die erfindungsgemäße erste Positionsmesseinrichtung, welche eine Kombination aus einem Interferometer und einer gitterbasierten Positionsmesseinrichtung darstellt, umfasst im vorliegenden Ausführungsbeispiel eine Lichtquelle 2.1, eine am Objekt 1 angeordnete Maßverkörperung 3, einen entlang der dritten Achse z beabstandet vom Objekt angeordneten Reflektor 4, eine Retroreflektoranordnung 2.6 sowie eine Detektoranordnung 2.5. Die Lichtquelle 2.1, die Retroreflektoranordnung 2.6 und die Detektoranordnung 2.5 sind hierbei in einer Optikeinheit 2 angeordnet, die in der langen, ersten Hauptbewegungsachse y beabstandet vom Objekt 1 angeordnet ist.

Im Folgenden sei der Strahlengang erläutert, über den bei der ersten erfindungsgemäßen Positionsmesseinrichtung Positionssignale bzgl. der Bewegung entlang der dritten Achse z erzeugt werden.

Die Lichtquelle 2.1, beispielsweise eine geeignete Laserlichtquelle mit vorgeordneter Kollimatorlinse, emittiert ein kollimiertes Strahlenbündel entlang der y-Richtung, d.h. entlang der ersten Hauptbewegungsachse y, in Richtung des Objekts 1. In der Retroreflektoranordnung 2.6 der Optikeinheit 2 trifft das Strahlenbündel auf ein Strahlteilerelement 2.2, das hier als Strahlteilerwürfel ausgebildet ist. Über das Strahlteilerelement 2.2 bzw. dessen Strahlteilerfläche wird das darauf einfallende Strahlenbündel in einen Messstrahl und in einen Referenzstrahl aufgespalten. In Figur 2b ist der Messstrahl nachfolgend durchgehend dargestellt, der Referenzstrahl strichliniert.

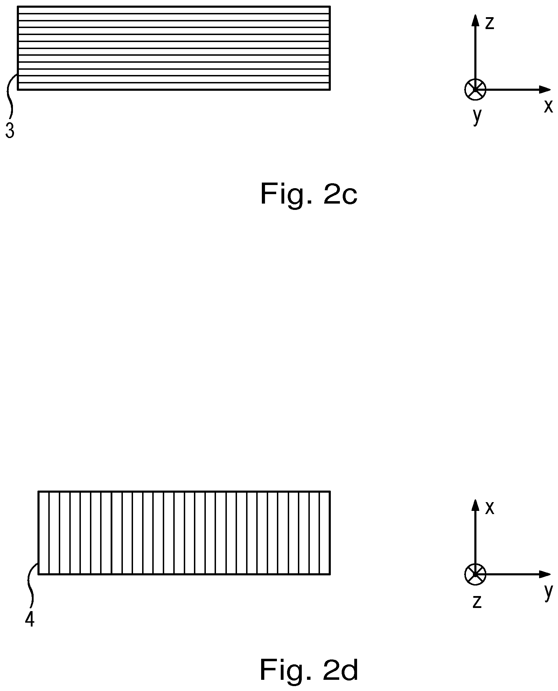

Der Messstrahl propagiert nach der Aufspaltung entlang der ersten Hauptbewegungsachse y in Richtung des Objekts 1 bzw. in Richtung einer am Objekt angeordneten Maßverkörperung 3. Die Maßverkörperung 3 besteht wie aus der Draufsicht in Figur 2c ersichtlich aus periodisch entlang der dritten Achse z angeordneten Teilungsmarkierungen mit unterschiedlichen optischen Reflexionseigenschaften, d.h. als Maßverkörperung 3 fungiert ein Auflicht-Beugungsgitter. Hierbei ist dieses derart ausgebildet, dass ein darauf einfallendes Strahlenbündel lediglich Beugung in +/-1. Ordnung erfährt und die 0. Ordnung unterdrückt wird. Im gezeigten Beispiel resultiert eine erste Reflexion und Beugung des einfallenden Messstrahls in Richtung des Reflektors 4. Zur Signalerzeugung genutzt wird in dieser Variante lediglich einer der beiden resultierenden Beugungsäste, nämlich derjenige in +1. Ordnung.

Die derart ausgebildete Maßverkörperung 3 erstreckt sich im vorliegenden Ausführungsbeispiel über die komplette Länge des Objektes 1 entlang der zweiten Hauptbewegungsachse x.

Der Reflektor 4 ist entlang der dritten Achse z beabstandet vom Objekt 1 angeordnet und mit einem gegenüber dem beweglichen Objekt 1 stationären Maschinenteil 5 gekoppelt. Im vorliegenden Ausführungsbeispiel ist der Reflektor 4 als Auflicht-Beugungsgitter ausgebildet, über das eine Rückreflexion des Messstrahls in sich selbst in Richtung der Maßverkörperung 3 am Objekt resultiert (Littrow-Anordnung). Gemäß Figur 2d, die eine Draufsicht auf den Reflektor 4 zeigt, besteht dieser aus periodisch entlang der ersten Hauptbewegungsachse y angeordneten Teilungsmarkierungen unterschiedlicher Reflektivität.

Über die Maßverkörperung 3 erfährt der Messstrahl sodann eine erste Rückreflexion in Richtung der Retroreflektoranordnung 2.6. Dort erfolgt im Strahlteilerelement 2.2 eine Umlenkung in Richtung des Retroreflektors 2.3 und anschließend eine Retroreflexion und eine erneute Reflexion in Richtung der Maßverkörperung 3 am Objekt 1. An der Maßverkörperung 3 resultiert eine zweite Reflexion und Beugung in Richtung des Reflektors 4, bevor der Messstrahl am Reflektor 4 eine zweite Reflexion und Beugung in Richtung der Maßverkörperung 3 erfährt. Von der Maßverkörperung 3 schließlich wird der Messstrahl ein zweites Mal in Richtung der Retroreflektoranordnung 2.6 zurückreflektiert.

Der am Strahlteilerelement 2.2 resultierende Referenzstrahl durchläuft in der nachfolgend erläuterten Art und Weise nach der Aufspaltung die Retroreflektoranordnung 2.6. So propagiert der Referenzstrahl zunächst in Richtung eines Referenzreflektors 2.4, beispielsweise ausgebildet als Planspiegel, wird von dort reflektiert und gelangt auf den Retroreflektor 2.3., welcher etwa als retroreflektierendes Prisma ausgebildet sein kann. Nach der darüber resultierenden Umlenkung propagiert der Referenzstrahl ein weiteres Mal in Richtung Referenzreflektor 2.4 und wird von diesem ein weiteres Mal in sich zurückreflektiert. An der Strahlteilerfläche des Strahlteilerelements 2.2 gelangt der Referenzstrahl mit dem vom Objekt 1 her einfallenden Messstrahl zur interferierenden Überlagerung. Das überlagerte Paar aus Mess- und Referenzstrahl propagiert anschließend in Richtung der - nur schematisch angedeuteten- Detektoranordnung 2.5. Die Detektoranordnung 2.5 kann hierbei als bekannte Interferometer-Detektoranordnung ausgebildet sein, die die Erfassung phasenverschobener Interferometersignale ermöglicht. Im Fall einer Bewegung des Objekts 1 inklusive Maßverkörperung 3 entlang der dritten Achse z resultieren an der Detektoranordnung 2.5 somit mehrere phasenverschobene Positionssignale mit einer Signalperiode P/4, wenn P die Teilungsperiode der Maßverkörperung 3 in z-Richtung darstellt.

Im Fall einer weiteren Bewegungskomponente des Objektes in der y-Richtung enthalten die über die Detektoranordnung 2.5 erzeugten Positionssignale zusätzliche Komponenten. Da die Objekt-Bewegung in dieser ersten Hauptbewegungsachse y üblicherweise über eine separate Positionsmesseinrichtung erfasst wird, ist diese Komponente bekannt, so dass in Verbindung mit dieser Information die erforderliche Positionsinformation bzw. der Objekt-Freiheitsgrad entlang der z-Richtung bestimmt werden kann.

Die Verwendung der Retroreflektoranordnung 2.6 dient in dieser Positionsmesseinrichtung zur Kompensation von Strahlscherungen aufgrund von eventuellen Verkippungen des bewegten Objektes 1 gegenüber der Nominallage. Es sei hierbei darauf hingewiesen, dass die Retroreflektoranordnung 2.6 im Rahmen der vorliegenden Erfindung und insbesondere dessen retroreflektierende Wirkung auf den Messstrahl auch alternativ zur dargestellten Ausführungsform umgesetzt werden kann; beispielswese könne auch andere Prismen- und/oder Spiegelkombinationen zum Einsatz kommen.

Die Erzeugung von Positionssignalen bzgl. der Objekt-Bewegung entlang der dritten Achse z erfolgt in der erläuterten ersten Positionsmesseinrichtung somit durch eine optische Abtastung des Objekts 1 bzw. der daran angeordneten Maßverkörperung 3 aus einer einzigen Antastrichtung die mit der ersten Hauptbewegungsachse y mit dem längeren Verfahrweg zusammenfällt.

Neben der dargestellten Variante der ersten erfindungsgemäßen Positionsmesseinrichtung gibt es noch alternative Ausführungsformen hierzu. So kann etwa vorgesehen werden, den Reflektor 4 oberhalb des Objekts 1 als Planspiegel auszubilden, der senkrecht zum darauf einfallenden Messstrahl angeordnet ist. Desweiteren ist es möglich, nicht nur einer der beiden resultierenden +/- 1. Beugungsordnungen an der Maßverkörperung 3 zu nutzen, sondern beide resultierenden Beugungsordnungen. Hierzu müsste dann ein zweiter Reflektor unterhalb des Objektes 1 vorgesehen werden, der analog zum Reflektor 4 aus dem erläuterten Beispiel ausgebildet ist. Ferner kann in einer entsprechenden Anordnung vorgesehen werden, die beschriebene erste Positionsmesseinrichtung in mehrfacher Ausführung einzusetzen, je nach den gegebenen Messanforderungen.

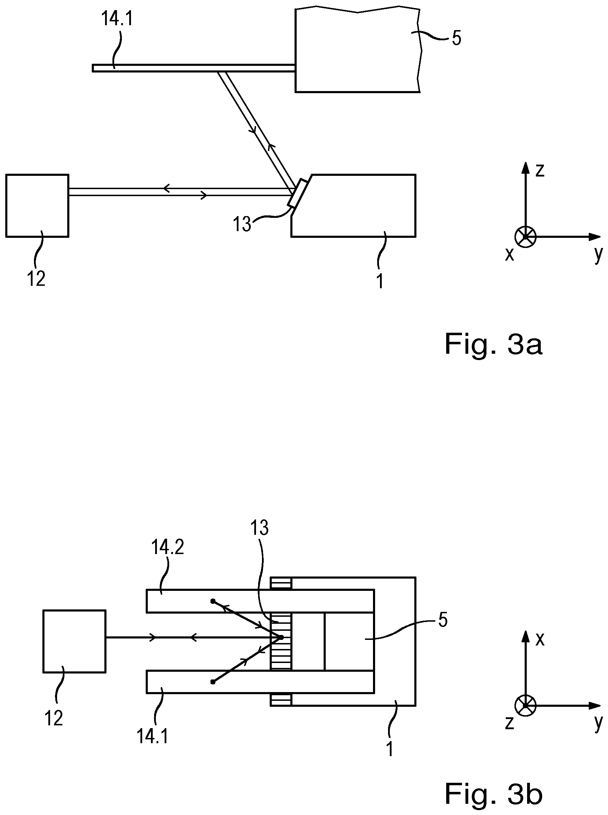

Eine zweite erfindungsgemäße Positionsmesseinrichtung wird nachfolgend anhand der Figuren 3a - 3d erläutert. Die zweite Positionsmesseinrichtung dient zur Erfassung der Position eines Objektes 1 entlang der zweiten Hauptbewegungsachse x, d.h. entlang der kürzeren der beiden Hauptbewegungsachsen x, y aus Figur 1. Wie schon die erste erfindungsgemäße Positionsmesseinrichtung kann auch die zweite Positionsmesseinrichtung grundsätzlich separat, d.h. unabhängig von der nachfolgend noch zu erläuternden beispielhaften (Gesamt-) Anordnung zur Positionsbestimmung eingesetzt werden.

Die erfindungsgemäße zweite Positionsmesseinrichtung umfasst im vorliegenden Ausführungsbeispiel eine Lichtquelle 12.1, eine am Objekt 1 angeordnete Maßverkörperung 13, einen entlang der dritten Achse z beabstandet vom Objekt angeordneten, Reflektor 14.1, 14.2, eine Retroreflektoranordnung 12.6 sowie eine Detektoranordnung 12.5. Der Reflektor ist im dargestellten Ausführungsbeispiel hierbei zweiteilig ausgebildet. Die Lichtquelle 12.1, die Retroreflektoranordnung 12.6 und die Detektoranordnung 12.5 sind in einer Optikeinheit 12 angeordnet, die in der langen, ersten Hauptbewegungsachse y beabstandet vom Objekt 1 angeordnet ist. Auch die Erfassung des Objekt-Freiheitsgrades in der zweiten Hauptbewegungsachse x erfolgt somit über eine optische Abtastung des Objektes 1 bzw. der daran angeordneten Komponenten der Positionsmesseinrichtung aus einer Antastrichtung, die mit der ersten Hauptbewegungsachse y des Objektes 1 zusammenfällt.

Nachfolgend wird anhand der Figuren der Strahlengang erläutert, über den bei der zweiten erfindungsgemäßen Positionsmesseinrichtung Positionssignale bzgl. der Bewegung entlang der kürzeren, zweiten Hauptbewegungsachse x erzeugt werden.

Die Lichtquelle 12.1, beispielsweise wieder ausgebildet als Laser-Lichtquelle mit vorgeordneter Kollimatorlinse, emittiert ein kollimiertes Strahlenbündel entlang der y-Richtung, d.h. entlang der ersten Hauptbewegungsachse y, in Richtung des Objekts 1. In der Retroreflektoranordnung 12.6 der Optikeinheit 12 trifft das emittierte Strahlenbündel auf ein Strahlteilerelement 12.2, das als Strahlteilerwürfel ausgebildet ist. Im Strahlteilerelement 12.2 passiert das Strahlenbündel eine Umlenkfläche 12.7 und propagiert entlang der ersten Hauptbewegungsachse y in Richtung des Objekts 1 bzw. in Richtung der am Objekt 1 angeordneten Maßverkörperung 13.

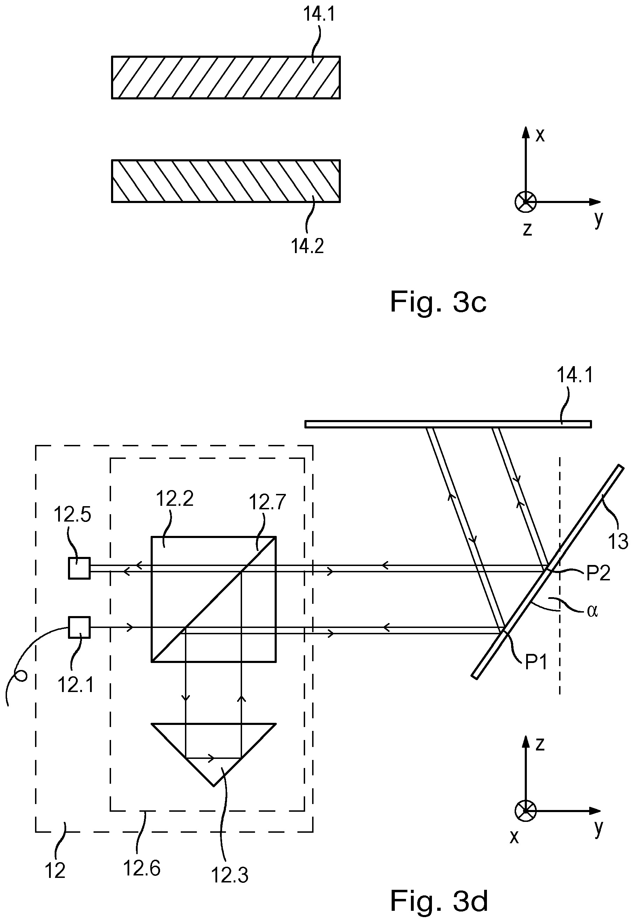

Im dargestellten Ausführungsbeispiel der zweiten erfindungsgemäßen Positionsmesseinrichtung ist die Maßverkörperung 13 am Objekt nunmehr nicht senkrecht in Bezug auf das einfallende Strahlenbündel bzw. parallel zur dritten Achse z angeordnet, sondern in einem Winkel α ungleich 90° zur z-Achse bzw. antiparallel zur z-Achse, wie dies aus Figur 3d ersichtlich ist.

Die Maßverkörperung 13, die sich über die komplette Länge des Objektes 1 entlang der zweiten Hauptbewegungsachse x erstreckt, besteht wie aus der Darstellung in Figur 3b erkennbar aus periodisch entlang der zweiten Hauptbewegungsachse x angeordneten Teilungsmarkierungen mit unterschiedlichen optischen Reflexionseigenschaften. Als Maßverkörperung 13 fungiert somit ein Auflicht-Beugungsgitter. Hierbei ist dieses derart ausgebildet, dass das an einem ersten Auftreffort P1 darauf einfallende Strahlenbündel lediglich Beugung in +/-1. Ordnung erfährt und die 0.Ordnung unterdrückt wird. Im dargestellten Ausführungsbeispiel der zweiten erfindungsgemäßen Positionsmesseinrichtung gezeigten Beispiel resultiert eine erste Reflexion und Beugung bzw. Aufspaltung des einfallenden Strahlenbündels in zwei Teilstrahlenbündel, die in Richtung des zweiteiligen Reflektors 14.1, 14.2 propagieren, wie dies in Figur 3b angedeutet ist. Der Reflektor 14.1, 14.2 ist entlang der dritten Achse z beabstandet vom Objekt 1 angeordnet und mit einem gegenüber dem Objekt 1 stationären Maschinenteil 5 mechanisch verbunden.

In der zweiten erfindungsgemäßen Positionsmesseinrichtung fungieren somit die beiden an der Maßverkörperung 13 aufgespaltenen Teilstrahlenbündel als Mess- und Referenzstrahl. Diese werden zur interferentiellen Erzeugung von Positionssignalen bezüglich der Objektbewegung entlang der zweiten Hauptbewegungsachse x genutzt. Strenggenommen handelt es sich hierbei im Unterschied zur ersten erfindungsgemäßen Positionsmesseinrichtung eigentlich um zwei Messstrahlen, da beide Messstrahlen das bewegte Objekt 1 beaufschlagen; demgegenüber gelangte der Referenzstrahl in der ersten Positionsmesseinrichtung nicht auf das Objekt 1. Es sei im folgenden jedoch aus Gründen der einheitlichen Terminologie auch in der zweiten Positionsmesseinrichtung die Rede von einem Mess- und einem Referenzstrahl, aus deren Überlagerung die interessierenden Positionssignale erzeugt werden.
Im dargestellten Ausführungsbeispiel der zweiten erfindungsgemäßen Positionsmesseinrichtung umfasst der Reflektor 14.1, 14.2 zwei, in Richtung der zweiten Hauptbewegungsachse x beabstandete Auflicht-Beugungsgitter, die aus periodisch angeordneten Teilungsmarkierungen unterschiedlicher Reflektivität bestehen. Gemäß der Ansicht der beiden Auflicht-Beugungsgitter des Reflektors 14.1, 14.2 in Figur 3c verlaufen die Teilungsmarkierungen schräg gegenüber der zweiten Hauptbewegungsachse x. Aufgrund der derart gewählten Ausbildung der Auflicht-Beugungsgitter bzw. des Reflektors 14.1, 14.2 werden die beiden Teilstrahlenbündel in sich selbst in Richtung der Maßverkörperung 13 am Objekt 1 zurückreflektiert (Littrow-Anordnung).

Über die Maßverkörperung 13 erfahren die beiden Teilstrahlenbündel sodann eine erste Rückreflexion in Richtung der Retroreflektoranordnung 12.6. Dort erfolgt im Strahlteilerelement 12.2 an der Umlenkfläche 12.7 eine Umlenkung der beiden einfallenden Teilstrahlenbündel in Richtung des Retroreflektors 12.3 und anschließend eine Retroreflexion und eine erneute Reflexion der Teilstrahlenbündel an der Umlenkfläche 12.7. in Richtung der Maßverkörperung 13 am Objekt 1. Auf der Maßverkörperung 13 treffen die beiden Teilstrahlenbündel dann auf einem zweiten Auftreffort P2 ein, der in z-Richtung beabstandet zum ersten Auftreffort P1 des Strahlenbündels ist. Von der Maßverkörperung 13 resultiert schließlich eine zweite Reflexion der Teilstrahlenbündel in Richtung des Reflektors 14.1, 14.2. Am Reflektor 14.1, 14.2 erfahren die beiden Teilstrahlenbündel dann eine zweite Reflexion in Richtung der Maßverkörperung 13. Auf der Maßverkörperung 13 werden die Teilstrahlenbündel, respektive der Mess- und Referenzstrahl, wiedervereinigt und propagieren als ein überlagertes Strahlenbündel in Richtung der wiederum nur schematisch angedeuteten Detektoranordnung 12.5. Im Fall einer Bewegung des Objekts 1 inklusive Maßverkörperung 13 entlang der zweiten Hauptbewegungsachse x werden über die Detektoranordnung 12.5 mehrere phasenverschobene Positionssignale erzeugt, die z.B. zur Bewegungssteuerung des Objekts 1 nutzbar sind.

Aufgrund des gewählten Strahlenganges mit der zweimaligen Beaufschlagung der Maßverkörperung 13 und dem dazwischen vorgesehenen Durchlaufen der Retroreflektoranordnung 2.6 lassen sich resultierende Einbrüche der Positionssignale aufgrund von Verkippungen des bewegten Objektes 1 kompensieren. Im Fall solcher Verkippungen würden Strahlscherungen und Moire-Effekte die Folge sein und zu den erwähnten Einbrüchen in der Intensität der Positionssignale führen.

Neben dem dargestellten Ausführungsbeispiel der zweiten erfindungsgemäßen Positionsmesseinrichtung existieren selbstverständlich noch alternative Ausführungsformen.

Beispielsweise kann etwa vorgesehen werden, den Reflektor 14.1, 14.2 oberhalb des Objekts 1 mittels zweier Planspiegel auszubilden, die jeweils senkrecht zum darauf einfallenden Teilstrahlenbündel angeordnet sind. Desweiteren ist es möglich, die am Objekt 1 unter dem Winkel α gegen die dritte Achse z angeordnete eindimensionale Maßverkörperung 13 durch eine zweidimensionale Maßverkörperung zu ersetzen, die parallel zur dritten Achse z am Objekt angeordnet wird. Diese umfasst neben den periodischen Teilungsmarkierungen entlang der zweiten Hauptbewegungsachse x dann noch periodisch entlang der dritten Achse z angeordnete Teilungsmarkierungen.

Desweiteren ist es möglich, anstelle der + 1. und -1. Beugungsordnung auch zwei andere, ungleiche Beugungsordnungen für den Mess- und Referenzstrahlengang zu nutzen und zur interferierenden Überlagerung zu bringen.

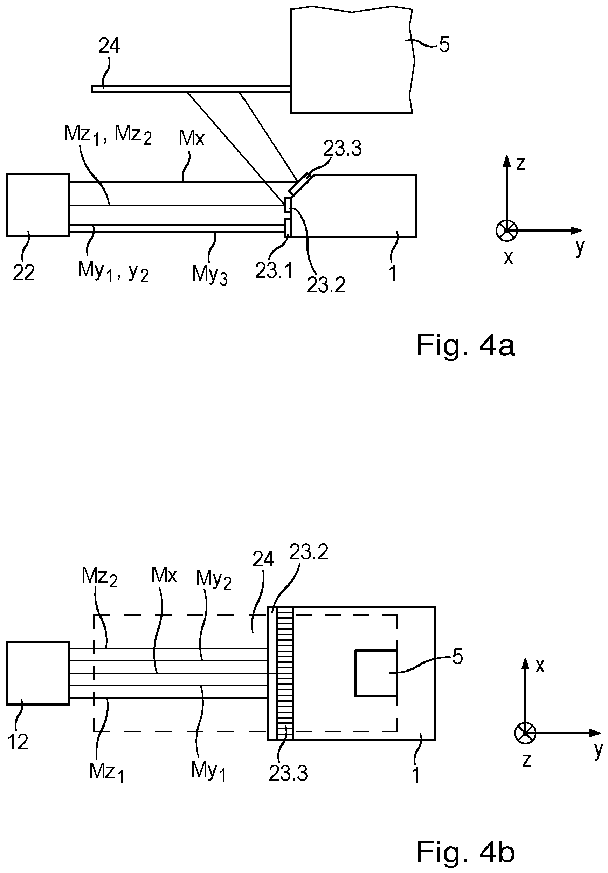

Anhand der Figuren 4a - 4d sei abschließend nunmehr eine beispielhafte Anordnung beschrieben, die zur Positionserfassung eines Objekts 1 in sechs Freiheitsgraden mittels mehrerer Positionsmesseinrichtungen geeignet ist. Das Objekt 1, beispielsweise wiederum ein Tisch in einer Maschine zur Halbleiterfertigung oder -inspektion, ist hierbei wie in Figur 1 skizziert entlang einer ersten und zweiten Hauptbewegungsachse y, x sowie entlang einer hierzu senkrechten dritten Achse z beweglich. Die erste Hauptbewegungsachse y stellt wiederum die längere der beiden Verfahrachsen in x- und y-Richtung dar; das Objekt 1 ist entlang dieser ersten Hauptbewegungsachse y um einen Betrag verschiebbar, der deutlich länger als die Ausdehnung des Objekts 1 in dieser Richtung ist.

In den Figuren 4a, 4b sind hierbei nur stark schematisiert die maßgeblichen Mess-Strahlengänge angedeutet, die zur Positionserfassung bzw. Positionsbestimmung des Objekts 1 in sechs Freiheitsgraden genutzt werden; auf eine Darstellung der detaillierten Strahlengänge der einzelnen Positionsmesseinrichtungen wurde aus Übersichtlichkeitsgründen verzichtet. Insbesondere ist hierbei u.a. nicht ersichtlich, dass die verschiedenen Messstrahlen zweimal in Richtung des Objekts 1 propagieren.

Zur Erfassung der Bewegung des Objekts 1 entlang der ersten Hauptbewegungsachse y und zur Erfassung der Rotationsbewegungen Rx, Rz des Objekts 1 um die zweite Hauptbewegungsachse x und die dritte Achse z ist eine an sich bekannte Positionsmesseinrichtung vorgesehen. Diese ist als sog. 3-Achs-Interferometer ausgebildet, wie es z.B. aus der US 6,542,247 B2 bekannt ist.

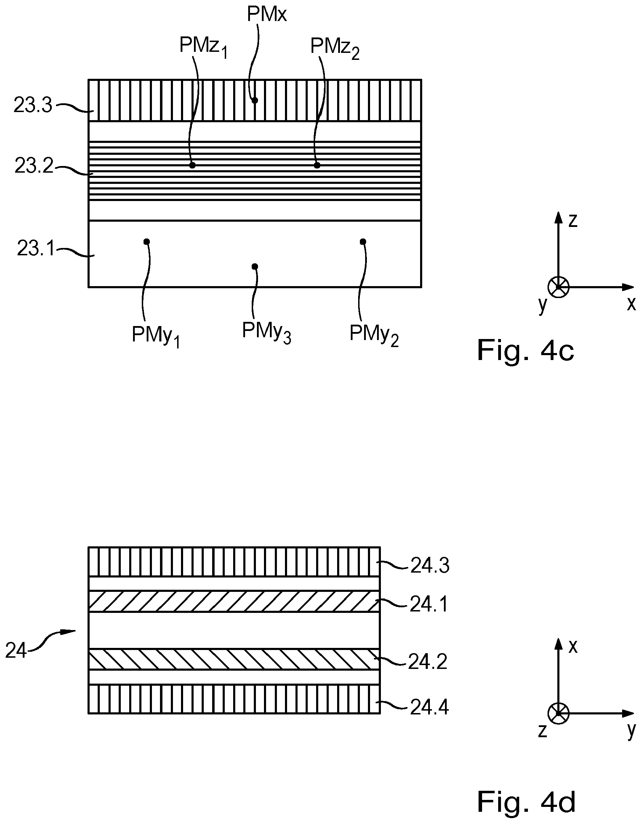

Das in der beispielhaften Anordnung eingesetzte 3-Achs-Interferometer nutzt drei Messstrahlen My₁, My₂, My₃, die jeweils aus der Richtung der zweiten Hauptbewegungsachse y her das Objekt 1 abtasten. Am Objekt 1 ist hierzu ein Messreflektor 23.1 angeordnet, auf den die drei Messstrahlen My₁, My₂, My₃ wie aus den Figuren 4a, 4b ersichtlich einfallen und von dort wieder in Richtung der Optikeinheit 12 zurückreflektiert werden. Der Messreflektor 23.1 ist am Objekt 1 an derjenigen Seite angeordnet, die der Optikeinheit 12 in der zweiten Hauptbewegungsachse y zugeordnet ist. In Figur 4c ist der Messreflektor 23.1 aus der Antastrichtung erkennbar, ferner die Auftreffpunkte PMy₁, PMy₂, PMy₃ der darauf einfallenden drei Messstrahlen My₁, My₂, My₃. In der Optikeinheit 12 sind die weiteren Optik-Komponenten des 3-Achs-Interferometers als auch der weiteren Positionsmesseinrichtungen der beispielhaften Anordnung untergebracht. Im Fall des 3-Achs-Interferometers handelt es sich unter anderem etwa um eine geeignete Lichtquelle, ein oder mehrere Strahlteilerelemente, einen Referenzreflektor und eine Detektoranordnung.

Wie aus den Figuren 4a, 4b und 4c ersichtlich, verlaufen erste und zweite Messstrahlen My₁, My₂ dieser Positionsmesseinrichtung bzw. des 3-Achs-Interferometers auf gleicher Höhe in z-Richtung und treffen in x-Richtung beabstandet voneinander an den Auftreffpunkten PMy₁, PMy₂ auf den Messreflektor 23.1. In z-Richtung unterhalb der beiden ersten und zweiten Messstrahlen My₁, My₂ verläuft im dargestellten Beispiel der dritte Messstrahl My₃ des 3-Achs-Interferometers, der am Auftreffpunkt PMy₃ auf den Messreflektor 23.1 trifft.

Aus den Abstandssignalen, die über derartige drei Messstrahlen My₁, My₂, My₃ gewonnen werden, können somit drei Freiheitsgrade bzgl. der Objektbewegung erfasst werden. Die entsprechenden Abstandssignale resultieren hierbei jeweils aus der interferierenden Überlagerung der Messstrahlen My₁, My₂, My₃ mit - nicht dargestellten - Referenzstrahlen und der Detektion der entsprechenden Signale über geeignete Detektoranordnungen. Es handelt sich wie eingangs erwähnt um die Bewegung des Objekts 1 entlang der ersten Hauptbewegungsachse y und die Rotationsbewegungen Rx, Rz des Objekts 1 um die zweite Hauptbewegungsachse x und die dritte Achse z.

Zur Erfassung der Bewegung des Objekts 1 in zwei weiteren Freiheitsgraden, nämlich der Bewegung des Objekts 1 entlang der dritten Achse z und zur Erfassung der Rotationsbewegung Ry des Objekts 1 um die erste Hauptbewegungsachse y dienen zwei weitere Positionsmesseinrichtungen, die jeweils einen Aufbau bzw. Strahlengang besitzen wie die oben im Detail erläuterte erste Positionsmesseinrichtung. Die beiden genutzten Messstrahlen dieser Positionsmesseinrichtungen werden in den Figuren 4a und 4b mit den Bezugszeichen Mz₁, Mz₂ bezeichnet und verlaufen auf gleicher Höhe in z-Richtung und in x-Richtung beabstandet voneinander. Am Objekt 1 treffen die beiden Messstrahlen Mz₁, Mz₂ dieser Positionsmesseinrichtung wie oben beschrieben auf den beiden Auftreffpunkten PMz₁, PMz₂ auf die Maßverkörperung 23.2, über die eine Umlenkung zum Reflektor 24 erfolgt. Vom Reflektor 24 werden die entsprechenden Messstrahlen Mz₁, Mz₂ dieser beiden Positionsmesseinrichtungen wieder über die Maßverkörperung 23.2 zurück in Richtung der Optikeinheit 12 reflektiert, wo auch die verschiedenen weiteren erforderlichen Optik-Komponenten dieser beiden Positionsmesseinrichtungen angeordnet sind.

Die erforderliche Maßverkörperung 23.2 für diese beiden Positionsmesseinrichtungen ist wie der Messreflektor 23.1 des 3-Achs-Interferometers am Objekt 1 an derjenigen Seite angeordnet, die der Optikeinheit 12 in der zweiten Hauptbewegungsachse y zugeordnet ist; Figur 4c zeigt eine Draufsicht dieser Seite aus der Antastrichtung.

Um schließlich den sechsten Freiheitsgrad des beweglichen Objektes 1 zu erfassen, nämlich die Bewegung des Objekts 1 entlang der zweiten Hauptbewegungsachse x, ist eine Positionsmesseinrichtung in der

Anordnung vorgesehen, die der oben erläuterten zweiten Positionsmesseinrichtung entspricht. Der zugehörige Messstrahl ist in den Figuren 4a, 4b mit Mx bezeichnet und trifft am Auftreffpunkt PMx auf die am Objekt 1 angeordnete Maßverkörperung 23.3. Auch diese Maßverkörperung 23.3 ist wie die andere Maßverkörperung 23.2 und der Messreflektor 23.1 des 3-Achs-Interferometers am Objekt 1 an derjenigen Seite angeordnet, die der Optikeinheit 12 in der zweiten Hauptbewegungsachse y zugeordnet ist. Von der Maßverkörperung 23.3 aus erfolgt die Aufspaltung und Umlenkung des Messstrahls Mx bzw. der entsprechenden Teilstrahlenbündel in Richtung des Reflektors 24; der nachfolgende Strahlengang entspricht demjenigen, der oben in Verbindung mit der zweiten erfindungsgemäßen Positionsmesseinrichtung beschrieben wurde. Auch die weiteren Optikkomponenten dieser Positionsmesseinrichtung sind in der Optikeinheit 12 angeordnet.

In Figur 4d ist die Seite des Reflektors 24 gezeigt, auf die die von den Maßverkörperungen 23.2, 23.2 gebeugten Messstrahlen Mz₁, Mz₂ und Mx auftreffen und in Littrow-Anordnung wieder zurückreflektiert werden. Neben den beiden zentral angeordneten Reflektoren 24.1, 24.2 für den Messstrahl Mx sind die beiden außen angeordneten Reflektoren 23.3, 24.4 für die Messstrahlen Mz₁, Mz₂ erkennbar. Die verschiedenen Reflektoren sind wie oben erläutert jeweils als Auflicht-Beugungsgitter ausgebildet.

Über diese Anordnung kann nunmehr die Position des beweglichen Objektes 1 in allen sechs Freiheitsgraden erfasst werden. Maßgeblich an der vorgeschlagenen Anordnung ist hierbei, dass die optischen Abtastungen aller verwendeten Positionsmesseinrichtungen aus einer einzigen Antastrichtung her erfolgen. Im dargestellten Beispiel ist dies die erste Hauptbewegungsrichtung y, entlang der gegenüber der zweiten Hauptbewegungsrichtung x ein deutlich längerer Verfahrweg für das Objekt 1 möglich ist. Entlang dieser Richtung verlaufen alle Messstrahlen My₁, My₂, My₃, Mz₁, Mz₂ und Mx der verschiedenen, eingesetzten Positionsmesseinrichtungen.

Neben den erläuterten Ausführungsbeispielen der erfindungsgemäßen Positionsmesseinrichtungen bzw. der beispielhaften Anordnung gibt es selbstverständlich im Rahmen der vorliegenden Erfindung noch weitere Ausgestaltungsmöglichkeiten. Dies betrifft etwa alternative Strahlengänge in den jeweiligen Positionsmesseinrichtungen, andere Varianten zur Realisierung von ggf. nötigen Referenzstrahlengängen oder alternative Varianten zur erforderlichen Retroreflexion etc..

## Patentansprüche

1. Positionsmesseinrichtung zur Erfassung der Position eines Objekts (1) entlang einer dritten Achse (z), die senkrecht zu zwei orthogonalen, ersten und zweiten Hauptbewegungsachsen (y, x) des Objekts (1) orientiert ist, mit
- einer Lichtquelle (2.1), die ein Strahlenbündel entlang der ersten Hauptbewegungsachse (y) in Richtung des Objekts (1) emittiert,
- einer am Objekt (1) angeordneten Maßverkörperung (3), die aus periodisch entlang der dritten Achse (z) angeordneten Teilungsmarkierungen besteht,
- mindestens einem entlang der dritten Achse (z) beabstandet vom Objekt (1) angeordneten Reflektor (4),
- einer Retroreflektoranordnung (2.6) und
- einer Detektoranordnung (2.5),
welche derart angeordnet und ausgebildet sind, dass aus der Überlagerung eines aus dem Strahlenbündel erzeugten Messstrahls und eines Referenzstrahls Positionssignale bezüglich der Bewegung des Objekts (1) entlang der dritten Achse (z) erzeugbar sind, wobei
- das von der Lichtquelle (2.1) emittierte Strahlenbündel in der Retroreflektoranordnung (2.6) eine Aufspaltung in einen Messstrahl und in einen Referenzstrahl erfährt,
- der Messstrahl in Richtung der Maßverkörperung (3) propagiert und darüber eine erste Reflexion und Beugung in Richtung des Reflektors (4) erfährt,
- der Messstrahl vom Reflektor (4) eine erste Rückreflexion in Richtung der Maßverkörperung (3) erfährt,
- der Messstrahl von der Maßverkörperung (3) eine erste Rückreflexion in Richtung der Retroreflektoranordnung (2.6) erfährt, wo der Messstrahl eine Retroreflexion und Rückreflexion in Richtung der Maßverkörperung (3) erfährt,
- der Messstrahl an der Maßverkörperung (3) eine zweite Reflexion und Beugung in Richtung des Reflektors (4) erfährt,
- der Messstrahl am Reflektor (4) eine zweite Rückreflexion in Richtung der Maßverkörperung (3) erfährt,
- der Messstrahl an der Maßverkörperung (3) eine zweite Rückreflexion in Richtung der Retroreflektoranordnung (2.6) erfährt und
- der Referenzstrahl die Retroreflektoranordnung (2.6) durchläuft und dann
- eine Überlagerung mit dem nach der zweiten Rückreflexion an der Maßverkörperung (3) her eintreffenden Messstrahl erfährt und das überlagerte Paar aus Mess- und Referenzstrahl in Richtung der Detektoranordnung (2.6) propagiert.

2. Positionsmesseinrichtung nach Anspruch 1, wobei die Retroreflektoranordnung (2.6) ein Strahlteilerelement (2.2), einen Referenzreflektor (2.4) sowie einen Retroreflektor (2.3) umfasst.

3. Positionsmesseinrichtung nach Anspruch 1, wobei der Reflektor (4) entweder
- als Auflicht-Beugungsgitter ausgebildet ist, das periodisch entlang der ersten Hauptbewegungsachse (y) angeordnete Teilungsmarkierungen umfasst oder
- als Planspiegel ausgebildet ist, der senkrecht zum darauf einfallenden Messstrahl angeordnet ist.

4. Positionsmesseinrichtung nach Anspruch 1, wobei die am Objekt (1) angeordnete Maßverkörperung (3) als Auflicht-Beugungsgitter derart ausgebildet ist, dass ein darauf einfallendes Strahlenbündel nur Beugung in +/- 1. Ordnung erfährt und die gebeugten Teilstrahlenbündel +/- 1. Ordnung eine Reflexion in Richtung des mindestens einen Reflektors (4) erfahren.

5. Positionsmesseinrichtung zur Erfassung der Position eines Objekts (1) entlang einer zweiten Hauptbewegungsachse (x), wobei das Objekt (1) beweglich entlang zweier orthogonaler, erster und zweiter Hauptbewegungsachsen (y, x) angeordnet ist, mit
- einer Lichtquelle (12.1), die ein Strahlenbündel entlang der ersten Hauptbewegungsachse (y) in Richtung des Objekts (1) emittiert,
- einer am Objekt (1) angeordneten Maßverkörperung (13), die periodisch entlang der zweiten Hauptbewegungsachse (x) angeordnete Teilungsmarkierungen umfasst,
- mindestens einem in Richtung einer dritten Achse (z) beabstandet vom Objekt (1) angeordneten Reflektor (14.1, 14.2), wobei die dritte Achse (z) senkrecht zu den beiden ersten und zweiten Hauptbewegungsachsen (y, x) orientiert ist
- einer Retroreflektoranordnung (12.6) und
- einer Detektoranordnung (12.5),
welche derart angeordnet und ausgebildet sind, dass aus der Überlagerung eines aus dem Strahlenbündel erzeugten Messstrahls und eines Referenzstrahls Positionssignale bezüglich der Bewegung des Objekts (1) entlang der zweiten Hauptbewegungsachse (x) erzeugbar sind, wobei
- das von der Lichtquelle (12.1) emittierte Strahlenbündel in Richtung der Maßverkörperung (13) propagiert und dort eine Aufspaltung in zwei Teilstrahlenbündel erfährt, welche als Mess- und Referenzstrahl zur interferentiellen Erzeugung von Positionssignalen nutzbar sind, und wobei die zwei Teilstrahlenbündel nach der Reflexion an der Maßverkörperung (13) in unterschiedlichen Richtungen zum Reflektor (14.1, 14.2) propagieren,
- die beiden Teilstrahlenbündel am Reflektor (14.1, 14.2) jeweils eine erste Rückreflexion in Richtung der Maßverkörperung (13) erfahren,
- die beiden Teilstrahlenbündel an der Maßverkörperung (13) eine erste Rückreflexion in Richtung der Retroreflektoranordnung (12.6) erfahren, wo die beiden Teilstrahlenbündel eine Retroreflexion und Rückreflexion in Richtung der Maßverkörperung (13) erfahren,
- die beiden Teilstrahlenbündel an der Maßverkörperung (13) eine zweite Reflexion und Beugung in Richtung des Reflektors (14.1, 14.2) erfahren,
- die beiden Teilstrahlenbündel am Reflektor (14.1, 14.2) eine zweite Rückreflexion in Richtung der Maßverkörperung (13) erfahren,
- eine Wiedervereinigung der Teilstrahlenbündel an der Maßverkörperung (13) erfolgt und von der Maßverkörperung (13) ein überlagertes Strahlenbündel in Richtung der Detektoranordnung (12.5) propagiert.

6. Positionsmesseinrichtung nach Anspruch 5, wobei der Reflektor (14.1, 14.2) entweder
- zwei, in Richtung der zweiten Hauptbewegungsachse (y) beabstandete Auflicht-Beugungsgitter umfasst, die periodisch angeordnete Teilungsmarkierungen aufweisen oder
- zwei, in Richtung der zweiten Hauptbewegungsachse (y) beabstandete Planspiegel umfasst, die jeweils senkrecht zum darauf einfallenden Messstrahl angeordnet sind.

7. Positionsmesseinrichtung nach Anspruch 5, wobei die am Objekt (1) angeordnete Maßverkörperung (3) als Auflicht-Beugungsgitter derart ausgebildet ist, dass ein darauf einfallendes Strahlenbündel nur Beugung in +/- 1. Ordnung erfährt und die gebeugten Teilstrahlenbündel +/- 1. Ordnung als Messstrahl und Referenzstrahl eine Reflexion in Richtung des mindestens einen Reflektors (14.1, 14.2) erfahren.

8. Positionsmesseinrichtung nach Anspruch 5, wobei die am Objekt (1) angeordnete Maßverkörperung (13) entweder
- als eindimensionale Maßverkörperung ausgebildet ist, die unter einem Winkel ungleich 0° zur dritten Achse (z) am Objekt (1) angeordnet ist oder
- als zweidimensionale Maßverkörperung ausgebildet ist, die parallel zur dritten Achse (z) am Objekt angeordnet ist und ferner periodisch entlang der dritten Achse (z) angeordnete Teilungsmarkierungen umfasst.

## Claims

1. Position measuring device for capturing the position of an object (1) along a third axis (z) that is oriented perpendicular to two orthogonal, first and second main movement axes (y, x) of the object (1), having
- a light source (2.1) that emits a beam along the first main movement axis (y) in the direction of the object (1),
- a material measure (3) that is arranged at the object (1) and that consists of graduation marks which are arranged at periodic intervals along the third axis (z),
- at least one reflector (4) that is arranged at a distance from the object (1) along the third axis (z),
- a retroreflector arrangement (2.6) and
- a detector arrangement (2.5),
which are arranged and embodied in such a way that position signals in respect of the movement of the object (1) along the third axis (z) are producible from the superposition of a measurement beam that was produced from the beam and a reference beam, wherein
- the beam emitted by the light source (2.1) experiences a split into a measurement beam and into a reference beam in the retroreflector arrangement (2.6),
- the measurement beam propagates in the direction of the material measure (3) and experiences a first reflection and diffraction in the direction of the reflector (4) thereby,
- the measurement beam experiences a first back-reflection in the direction of the material measure (3) at the reflector (4),
- the measurement beam experiences a first back-reflection in the direction of the retroreflector arrangement (2.6) at the material measure (3), the measurement beam experiencing a retroreflection and back-reflection in the direction of the material measure (3) at said retroreflector arrangement (2.6),
- the measurement beam experiences a second reflection and diffraction in the direction of the reflector (4) at the material measure (3),
- the measurement beam experiences a second back-reflection in the direction of the material measure (3) at the reflector (4),
- the measurement beam experiences a second back-reflection in the direction of the retroreflector arrangement (2.6) at the material measure (3) and
- the reference beam passes through the retroreflector arrangement (2.6) and then
- experiences a superposition with the measurement beam incident after the second back-reflection at the material measure (3) and the superposed pair of measurement and reference beam propagates in the direction of the detector arrangement (2.6).

2. Position measuring device according to Claim 1, wherein the retroreflector arrangement (2.6) comprises a beam splitter element (2.2), a reference reflector (2.4) and a retroreflector (2.3).

3. Position measuring device according to Claim 1, wherein the reflector (4) either
- is embodied as an incident light diffraction grating which comprises graduation marks that are arranged at periodic intervals along the first main movement axis (y) or
- is embodied as a plane mirror which is arranged perpendicular to the measurement beam incident thereon.

4. Position measuring device according to Claim 1, wherein the material measure (3) arranged at the object (1) is embodied as an incident light diffraction grating in such a way that a beam incident thereon only experiences diffraction into the +/-1^{st} order and the diffracted partial beams of the +/-1^{st} order experience a reflection in the direction of the at least one reflector (4).

5. Position measuring device for capturing the position of an object (1) along a second main movement axis (x), wherein the object (1) is movably arranged along two orthogonal, first and second main movement axes (y, x), having
- a light source (12.1) that emits a beam along the first main movement axis (y) in the direction of the object (1),
- a material measure (13) that is arranged at the object (1) and that consists of graduation marks which are arranged at periodic intervals along the second main movement axis (x),
- at least one reflector (14.1, 14.2) that is arranged at a distance from the object (1) in the direction of a third axis (z), wherein the third axis (z) is oriented perpendicular to two orthogonal, first and second main movement axes (y, x),
- a retroreflector arrangement (12.6) and
- a detector arrangement (12.5),
which are arranged and embodied in such a way that position signals in respect of the movement of the object (1) along the second main movement axis (x) are producible from the superposition of a measurement beam that was produced from the beam and a reference beam, wherein
- the beam emitted by the light source (12.1) propagates in the direction of the material measure (13) and experiences a split into two partial beams there, which are usable as measurement and reference beam for interference-based production of position signals, and wherein the two partial beams propagate in different directions for the reflector (14.1, 14.2) after the reflection at the material measure (13),
- the two partial beams each experience a first back-reflection in the direction of the material measure (13) at the reflector (14.1, 14.2),
- the two partial beams experience a first back-reflection in the direction of the retroreflector arrangement (12.6) at the material measure (13), both partial beams experiencing a retroreflection and back-reflection in the direction of the material measure (13) at said retroreflector arrangement,
- the two partial beams experience a second reflection and diffraction in the direction of the reflector (14.1, 14.2) at the material measure (13),
- the two partial beams experience a second back-reflection in the direction of the material measure (13) at the reflector (14.1, 14.2),
- there is a reunification of the partial beams at the material measure (13) and a superposed beam propagates from the material measure (13) in the direction of the detector arrangement (12.5).

6. Position measuring device according to Claim 5, wherein the reflector (14.1, 14.2) either
- comprises two incident light diffraction gratings having graduation marks arranged at periodic intervals, said incident light diffraction gratings being spaced apart in the direction of the second main movement axis (y), or
- comprises two plane mirrors, each being arranged perpendicular to the measurement beam incident thereon, said plane mirrors being spaced apart in the direction of the second main movement axis (y).

7. Position measuring device according to Claim 5, wherein the material measure (3) arranged at the object (1) is embodied as an incident light diffraction grating in such a way that a beam incident thereon only experiences diffraction into the +/-1^{st} order and the diffracted partial beams of the +/-1^{st} order, as measurement beam and reference beam, experience a reflection in the direction of the at least one reflector (14.1, 14.2) .

8. Position measuring device according to Claim 5, wherein the material measure (13) arranged at the object (1) either
- is embodied as a one-dimensional material measure which is arranged at an angle not equal to 0° in relation to the third axis (z) at the object (1) or
- is embodied as a two-dimensional material measure which is arranged parallel to the third axis (z) at the object and further comprises graduation marks that are arranged at periodic intervals along the third axis (z).

## Revendications

1. Dispositif de mesure de position destiné à détecter la position d'un objet (1) le long d'un troisième axe (z), qui est orienté perpendiculaire à deux premier et deuxième axes de déplacement principaux orthogonaux (y, x) de l'objet (1), comportant
- une source de lumière (2.1), qui émet un faisceau de rayonnement le long du premier axe de déplacement principal (y) dans la direction de l'objet (1),
- une mesure matérialisée (3) disposée sur l'objet (1), qui est constituée de graduations disposées périodiquement le long du troisième axe (z),
- au moins un réflecteur (4) disposé le long du troisième axe (z) de manière espacée de l'objet (1),
- un dispositif rétroréflecteur (2.6) et
- un dispositif détecteur (2.5),
qui sont disposés et conçus de manière à ce que des signaux de position concernant le mouvement de l'objet (1) le long du troisième axe (z) puissent être générés à partir de la superposition d'un faisceau de mesure généré à partir du faisceau de rayonnement et d'un faisceau de référence, dans lequel
- le faisceau de rayonnement émis par la source de lumière (2.1) est soumis à une division en un faisceau de mesure et un faisceau de référence dans le dispositif rétroréflecteur (2.6),
- le faisceau de mesure se propage dans la direction de la mesure matérialisée (3) et subit une première réflexion et diffraction dans la direction du réflecteur (4),
- le faisceau de mesure provenant du réflecteur (4) est soumis à une première réflexion de retour dans la direction de la mesure matérialisée (3),
- le faisceau de mesure provenant de la mesure matérialisée (3) est soumis à une première réflexion de retour dans la direction du dispositif rétroréflecteur (2.6), où le faisceau de mesure est soumis à une rétroréflexion et à une réflexion de retour dans la direction de la mesure matérialisée (3),
- le faisceau de mesure est soumis à une deuxième réflexion et diffraction sur la mesure matérialisée (3) dans la direction du réflecteur (4),
- le faisceau de mesure est soumis à une deuxième réflexion de retour dans la direction de la mesure matérialisée (3) dans la direction du réflecteur (4),
- le faisceau de mesure est soumis à une deuxième réflexion de retour dans la direction du dispositif rétroréflecteur (2.6) sur la mesure matérialisée (3) et
- le faisceau de référence passe à travers le dispositif rétroréflecteur (2.6), puis
- est soumis à une superposition au faisceau de mesure atteignant la mesure matérialisée (3) après la deuxième réflexion de retour, et la paire superposée composée du faisceau de mesure et du faisceau de référence se propage dans la direction du dispositif détecteur (2.6).

2. Dispositif de mesure de position selon la revendication 1, dans lequel le dispositif rétroréflecteur (2.6) comprend un élément diviseur de faisceau (2.2), un réflecteur de référence (2.4) et un rétroréflecteur (2.3).

3. Dispositif de mesure de position selon la revendication 1, dans lequel le réflecteur (4) est soit
- réalisé sous la forme d'un réseau de diffraction de lumière incidente comprenant des repères de graduation disposés périodiquement le long du premier axe de déplacement principal (y), soit
- réalisé sous la forme d'un miroir plan qui est disposé perpendiculairement au faisceau de mesure incident.

4. Dispositif de mesure de position selon la revendication 1, dans lequel la mesure matérialisée (3) disposée sur l'objet (1) est réalisée sous la forme d'un réseau de diffraction de lumière incidente de manière à ce qu'un faisceau de rayonnement incident sur celui-ci subisse uniquement une diffraction d'ordre +/-1 et à ce que des faisceaux de rayonnement partiels diffractés d'ordre +/-1 soient réfléchis dans la direction dudit au moins un réflecteur (4).

5. Dispositif de mesure de position destiné à détecter la position d'un objet (1) le long d'un deuxième axe de déplacement principal (x), dans lequel l'objet (1) est disposé de manière mobile le long de deux premier et deuxième axes de déplacement principaux orthogonaux (y, x), comportant
- une source de lumière (12.1), qui émet un faisceau de rayonnement le long du premier axe de déplacement principal (y) dans la direction de l'objet (1),
- une mesure matérialisée (13) disposée sur l'objet (1), qui comprend des repères de graduation disposés périodiquement le long du deuxième axe de déplacement principal (x),
- au moins un réflecteur (14.1, 14.2) disposé de manière espacée de l'objet (1) dans la direction d'un troisième axe (z), dans lequel le troisième axe (z) est orienté perpendiculairement aux deux premier et deuxième axes de déplacement principaux (y, x),
- un dispositif rétroréflecteur (12.6), et
- un dispositif détecteur (12.5),
qui sont disposés et conçus de manière à ce que des signaux de position concernant le déplacement de l'objet (1) le long du deuxième axe de déplacement principal (x) puissent être générés à partir de la superposition d'un faisceau de mesure généré à partir du faisceau de rayonnement et d'un faisceau de référence,
- le faisceau de rayonnement émis par la source de lumière (12.1) se propage dans la direction de la mesure matérialisée (13) et y est divisé en deux faisceaux de rayonnement partiels qui peuvent être utilisés en tant que faisceaux de mesure et de référence pour générer des signaux de position par interférence, et dans lequel les deux faisceaux de rayonnement partiels se propagent après réflexion sur la mesure matérialisée (13) dans des directions différentes par rapport au réflecteur (14.1, 14.2),
- les deux faisceaux de rayonnement partiels sont respectivement soumis à une première réflexion de retour dans la direction de la mesure matérialisée (13) sur le réflecteur (14.1, 14.2),
- les deux faisceaux de rayonnement partiels sont soumis à une première réflexion de retour dans la direction du dispositif rétroréflecteur (12.6) sur la mesure matérialisée (13), où les deux faisceaux de rayonnement partiels sont soumis à une rétroréflexion et à une réflexion de retour dans la direction de la mesure matérialisée (13),
- les deux faisceaux de rayonnement partiels sont soumis sur la mesure matérialisée (13) à une deuxième réflexion et diffraction dans la direction du réflecteur (14.1, 14.2),
- les deux faisceaux de rayonnement partiels sont soumis à une deuxième réflexion de retour dans la direction de la mesure matérialisée (13) sur le réflecteur (14.1, 14.2),
- les faisceaux de rayonnement partiels sont réunis sur la mesure matérialisée (13) et un faisceau de rayonnement superposé se propage depuis la mesure matérialisée (13) dans la direction du dispositif détecteur (12.5).

6. Dispositif de mesure de position selon la revendication 5, dans lequel le réflecteur (14.1, 14.2) comprend soit
- deux réseaux de diffraction de lumière incidente espacés l'un de l'autre dans la direction du deuxième axe de déplacement principal (y), qui comportant des repères de graduation disposés périodiquement, soit
- deux miroirs plans espacés dans la direction du deuxième axe de déplacement principal (y), qui sont respectivement disposés perpendiculairement au faisceau de mesure incident sur ceux-ci.

7. Dispositif de mesure de position selon la revendication 5, dans lequel la mesure matérialisée (3) disposée sur l'objet (1) est réalisée sous la forme d'un réseau de diffraction de lumière incidente de manière à ce qu'un faisceau de rayonnement incident sur celui-ci subisse uniquement une diffraction d'ordre +/- 1 et à ce que les faisceaux de rayonnement partiels diffractés d'ordre +/- 1 soient réfléchis dans la direction dudit au moins un réflecteur (14.1, 14.2) en tant que faisceau de mesure et que faisceau de référence.

8. Dispositif de mesure de position selon la revendication 5, dans lequel la mesure matérialisée (13) disposée sur l'objet (1) est soit
- réalisée sous la forme d'une mesure matérialisée unidimensionnelle qui est disposée sur l'objet (1) selon un angle différent de 0° par rapport au troisième axe (z), soit
- réalisée sous la forme d'une mesure matérialisée bidimensionnelle qui est disposée sur l'objet parallèlement au troisième axe (z) et comprend en outre des repères de graduation disposés périodiquement le long du troisième axe (z).
